(19) Europäisches Patentamt / European Patent Office / Office européen des brevets

(11) **EP 2 700 962 B1**

(12) **EUROPÄISCHE PATENTSCHRIFT**

(45) Veröffentlichungstag und Bekanntmachung des Hinweises auf die Patenterteilung:
**07.11.2018 Patentblatt 2018/45**

(51) Int Cl.:
**G01R 31/327** (2006.01)

(21) Anmeldenummer: **12006040.5**

(22) Anmeldetag: **24.08.2012**

(54) **Messung eines Widerstands eines Schaltkontakts eines elektrischen Leistungsschalters**

Measurement of a resistance of a switch contact of an electrical circuit breaker

Mesure d'une résistance d'un contacteur de commutation d'un disjoncteur électrique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**26.02.2014 Patentblatt 2014/09**

(60) Teilanmeldung:
**13196147.6 / 2 708 907**

(73) Patentinhaber: **Omicron electronics GmbH 6833 Klaus (AT)**

(72) Erfinder:
• **Klapper, Ulrich 6830 Rankweil (AT)**
• **De Villiers, Wernich 6850 Dornbirn (AT)**
• **Kaufmann, Reinhard 6721 Thüringerberg (AT)**

(74) Vertreter: **Banzer, Hans-Jörg et al Kraus & Weisert Patentanwälte PartGmbB Thomas-Wimmer-Ring 15 80539 München (DE)**

(56) Entgegenhaltungen:
**WO-A1-2004/095667 WO-A1-2009/131530 DE-A1- 3 715 014**

• **NILS WÄCKLÉN ET AL: "High voltage circuit breaker testing with dual grounding", ENERGIZE, Nr. May 2008, 1. Mai 2008 (2008-05-01), Seiten 52-55, XP055054228,**
• **ZORAN STANISIC: "Method for static and dynamic resistance measurements of HV circuit breaker", INNOVATIVE SMART GRID TECHNOLOGIES (ISGT EUROPE), 2011 2ND IEEE PES INTERNATIONAL CONFERENCE AND EXHIBITION ON, IEEE, 5. Dezember 2011 (2011-12-05), Seiten 1-5, XP032136558, DOI: 10.1109/ISGTEUROPE.2011.6162618 ISBN: 978-1-4577-1422-1**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft ein Verfahren und eine Vorrichtung zur Messung eines Widerstands eines Schaltkontakts eines elektrischen Leistungsschalters sowie ein Verfahren und eine Vorrichtung zur Messung von Widerständen von in einer Reihenschaltung angeordneten Schaltkontakten eines elektrischen Leistungsschalters. Die vorliegende Erfindung betrifft insbesondere eine Messung von Übergangswiderständen des geschlossenen Schaltkontakts oder der geschlossenen Schaltkontakte des elektrischen Leistungsschalters.

Leistungsschalter, welche auch als Hochspannungsschalter, Lastschalter oder Circuit Breaker bezeichnet werden, werden in der Energietechnik verwendet, um elektrische Verbindung unter Last herzustellen oder zu trennen. Die Nennspannungen der Leistungsschalter können im Bereich von wenigen Volt bis zu einigen hundert Kilovolt liegen. Die geschalteten Lastströme können bei einem Kurzschluss mehrere zehn Kiloampere betragen. Für einen zuverlässigen Betrieb des Leistungsschalters wird daher beispielsweise im Rahmen von Revisionen der Übergangswiderstand eines Schaltkontakts oder mehrerer in Reihe angeordneter Schaltkontakte des elektrischen Leistungsschalters überprüft.

Leistungsschalter für Mittelspannungsanlagen haben meist nur einen Schaltkontakt, welcher geöffnet oder geschlossen werden kann. Leistungsschalter in Hoch- und Höchstspannungsanlagen können mehrere Schaltkontakte, sogenannte Unterbrechereinheiten, in einer Reihenschaltung umfassen. Bei der Reihen- oder Serienschaltung mehrerer Unterbrechereinheiten werden im Allgemeinen noch Kondensatoren mit einer Größe im Bereich von einigen Pikofarad parallel zu den einzelnen Unterbrechereinheiten angeordnet, um die Spannung gleichmäßig über die einzelnen Unterbrechereinheiten zu verteilen. Mehrere Unterbrechereinheiten in einer Phase eines Leistungsschalters werden im Allgemeinen gleichzeitig geöffnet oder geschlossen.

Bei Leistungsschaltern ist die Widerstandsmessung am geschlossenen Schaltkontakt, welche auch als Mikroohmmessung bezeichnet wird, ein Standardverfahren zur Beurteilung einer Qualität oder eines Verschleißzustandes des Leistungsschalters.

In diesem Zusammenhang offenbart die Veröffentlichung von "NILS WÄCKLEN et al: "High voltage circuit breaker testing with dual grounding", ENERGIZE, Nr. May 2008, 1. Mai 2008 (2008-05-01), Seiten 52-55, XP055054228" ein Verfahren zum Testen eines Hochspannungsschalters mit einer doppelten Erdung. Bei dem Verfahren wird ein Leistungsschalter-Timing-Test durchgeführt, wobei beide Seiten während des Tests durchgehend geerdet sind. Bei dem Testverfahren wird ein Kontaktwiderstand gemessen, indem der Strom durch die Erde gemessen wird und die Berechnung entsprechend kompensiert wird. Der Erdschleifenstrom wird mit einer Stromzange gemessen, welche eine ausreichende Genauigkeit bereitstellt.

Die Mikroohmmessung wird üblicherweise durchgeführt, indem beispielsweise ein hoher Gleichstrom von 100 Ampere über den geschlossenen Schaltkontakt eingeprägt wird. Der Strom wird dazu über Stromklemmen eingespeist, welche an beiden Seiten des Leistungsschalters an die Leiter, welche vom Leistungsschalter wegführen, angeklemmt werden. Mit weiteren Klemmen wird die Spannung ebenfalls an beiden Seiten des Leistungsschalters abgegriffen. Die Spannungsklemmen werden üblicherweise näher am Schaltkontakt des Leistungsschalters angebracht und somit eine sogenannte Vierdrahtmessung durchgeführt. Dadurch kann verhindert werden, dass der Spannungsabfall an den Stromklemmen mitgemessen wird, wodurch das Messergebnis verfälscht werden würde. Aus eingeprägtem Strom und gemessener Spannung kann der Widerstand des geschlossenen Schaltkontakts inklusive des Widerstandes der Zuleitungen von den Spannungsklemmen bis zum Schaltkontakt bestimmt werden. Alternativ können statt getrennter Strom- und Spannungsklemmen sogenannte Kelvinklemmen zum Einsatz kommen. Bei Kelvinklemmen sind zwei Backen einer jeweiligen Klemme voneinander elektrisch isoliert und über eine der zwei Backen wird der Strom eingespeist und über die andere der zwei Backen wird die Spannung abgegriffen. Der Vorteil dieser Kelvinklemmen ist, dass nur eine Klemme an jeder Seite des Leistungsschalters anzuklemmen ist.

Zur Mikroohmmessung können, wie zuvor beschrieben wurde, eine Stromquelle und ein Spannungsmesser verwendet werden, sodass Spannungsmessungen an den verschiedenen Schaltkontakten nacheinander durchgeführt werden können. Es können auch mehrere Spannungsmesser verwendet werden, wobei mit einer gemeinsamen Stromquelle über mehrere Kontakte der Strom eingeprägt wird und mit den mehreren Spannungsmessern mehrere Spannungswerte gleichzeitig ermittelt werden können.

Da in energietechnischen Anlagen, beispielsweise in einem Umspannwerk, an vielen Stellen gefährlich hohe Spannungen auftreten können, ist es notwendig den Leistungsschalter während dieser Mikroohmmessung zu erden. Beispielsweise kann der Leistungsschalter an beiden Seiten vom übrigen Energienetz getrennt werden und an einer Seite geerdet werden. Die Mikroohmmessung kann dann bei geschlossenem Schaltkontakt oder geschlossenen Schaltkontakten präzise durchgeführt werden. Häufig sind weitere Messungen an dem Leistungsschalter durchzuführen, bei denen der Schaltkontakt zumindest zeitweise geöffnet sein muss, beispielsweise eine Messung der Zeit, die der Schalter zum Öffnen benötigt. Bei derartigen Messungen ist eine beidseitige Erdung des Schalters empfehlenswert, um eine Gefährdung von Personen, welche die Messung durchführen, zu vermeiden. Für die Mikroohmmessung wird daher eine der beiden Erdungen für die Dauer der Messung entfernt werden, was jedoch sehr umständlich ist, oder die Mikroohmmessung wird bei beidseitiger Erdung durch die parallele Erdschleife fehlerhaft.

Um eine Mikroohmmessung an einem Leistungsschalter effizient durchführen zu können, kann der Leistungsschalter beidseitig geerdet werden und mit einer gleichstromfähigen Stromzange oder einem Shunt der Anteil des Stroms, welcher von der Stromquelle durch die Erdungsgarnituren fließt, ermittelt werden und zur Korrektur des gemessenen Widerstands herangezogen werden. Dieses Verfahren ist zwar sehr genau, hat jedoch den Nachteil, dass zusätzliche Messungen mittels der Stromzange oder dem Shunt erforderlich sind.

Aufgabe der vorliegenden Erfindung ist es daher, eine effiziente Widerstandsmessung oder Mikroohmmessung für einen oder mehrere Schaltkontakte eines elektrischen Leistungsschalters zu ermöglichen, wobei eine Gefährdung von Personal, welches die Widerstandsmessung durchführt, weitestgehend vermieden werden sollte.

Diese Aufgabe wird gemäß der vorliegenden Erfindung durch ein Verfahren zur Messung eines Widerstands eines Schaltkontakts eines elektrischen Leistungsschalters nach Anspruch 1, eine Vorrichtung zur Messung eines Widerstands eines Schaltkontakts eines elektrischen Leistungsschalters nach Anspruch 6 und eine Testumgebung zur Messung eines Widerstands eines Schaltkontakts eines elektrischen Leistungsschalters nach Anspruch 8 gelöst. Die abhängigen Ansprüche definieren bevorzugte und vorteilhafte Ausführungsformen der Erfindung.

Gemäß der vorliegenden Erfindung wird ein Verfahren zur Messung eines Widerstands eines Schaltkontakts eines elektrischen Leistungsschalters bereitgestellt. Bei dem Verfahren wird ein erster Widerstandswert über dem Leistungsschalter bestimmt, während der Leistungsschalter beidseitig geerdet ist und der Schaltkontakt geschlossen ist. Weiterhin wird ein zweiter Widerstandswert über dem Leistungsschalter bestimmt, während der Leistungsschalter beidseitig geerdet ist und der Schaltkontakt geöffnet ist. In Abhängigkeit von dem ersten Widerstandswert und dem zweiten Widerstandswert wird der Widerstand des geschlossenen Schaltkontakts bestimmt. Die Erdung an beiden Seiten kann beispielsweise durch zwei Erdungsgarnituren von Erde zu den entsprechenden Leitern erreicht werden. Alternativ kann die Erdung mittels einer Erdungsgarnitur, die nur einmal an Erde angeschlossen ist und mehrere Anschlüsse hat, mit denen geerdet werden kann, durchgeführt werden. Der erste Widerstandswert bei geschlossenem Schaltkontakt entspricht einem Widerstand der Parallelschaltung aus geschlossenem Schalter und Erdung. Der zweite Widerstandswert entspricht dem Erdungswiderstand. Der Widerstand des geschlossenen Schaltkontakts $R_{Schalter}$ kann beispielsweise durch die folgende Gleichung bestimmt werden:

$$R_{schalter} = \frac{R_2 \bullet R_1}{R_2 - R_1}$$

Wobei $R_1$ der erste Widerstandswert und $R_2$ der zweite Widerstandswert ist. Da zwischen den beiden Messungen die Verdrahtung nicht Verändert werden muss, kann die Messung sehr genau durchgeführt werden.

Gemäß einer Ausführungsform werden der erste und zweite Widerstandswert jeweils bestimmt, indem ein Gleichstrom in den beidseitig geerdeten Leistungsschalter eingeprägt wird und eine Spannung über dem Leistungsschalter gemessen wird. Somit können übliche Mikroohmmessvorrichtungen zum Bestimmen des ersten und zweiten Widerstandswerts verwendet werden.

Der Leistungsschalter kann einen Dreiphasenschalter umfassen. Jeder Phase ist mindestens ein Schaltkontakt zugeordnet. Dreiphasige Schalter können einen gemeinsamen oder drei getrennte Antriebe umfassen. Bei einigen dreiphasigen Schaltern können auch einzelne Phasen individuell geschaltet werden, beispielsweise in Fällen, bei denen ein Fehler nur an einer Phase auftritt und somit auch nur die Abschaltung einer Phase notwendig ist. Das zuvor beschriebene Verfahren kann für jede Phase einzeln angewendet werden und ist daher auch für mehrphasige Leistungsschalter geeignet. Das Verfahren kann auch gleichzeitig an zwei oder mehr Phasen durchgeführt werden, wodurch eine Überprüfung eines mehrphasigen Schalters effizient durchgeführt werden kann. Gemäß einer weiteren Ausführungsform kann der Leistungsschalter einen Höchst- Hoch- oder Mittelspannungsschalter umfassen. Da das Verfahren unabhängig von der zu schaltenden Spannung des Leistungsschalters ist, kann es für Mittelspannungsschalter mit einer Nennspannung von beispielsweise 1 kV - 45 kV, einem Hochspannungsschalter mit einer Nennspannung von 45 kV - 150 kV oder einem Höchstspannungsschalter mit einer Nennspannung von über 150 kV angewendet werden.

Gemäß der vorliegenden Erfindung wird weiterhin eine Vorrichtung zur Messung eines Widerstands eines Schaltkontakts eines elektrischen Leistungsschalters bereitgestellt. Die Vorrichtung umfasst eine Ansteuereinheit zum Ansteuern des elektrischen Leistungsschalters, um den Schaltkontakt des Leistungsschalters wahlweise zu öffnen oder zu schließen. Die Vorrichtung umfasst weiterhin eine Widerstandsmesseinrichtung, welche mit der Ansteuereinheit und dem Leistungsschalter koppelbar ist. Die Widerstandsmesseinrichtung ist in der Lage, einen ersten Widerstandswert über dem Leistungsschalter zu bestimmen, während der Leistungsschalter beidseitig geerdet ist und der Schaltkontakt des Leistungsschalters geschlossen ist. Die Widerstandsmesseinrichtung ist ferner in der Lage, einen zweiten Widerstandswert über dem Leistungsschalter zu bestimmen, während der Leistungsschalter beidseitig geerdet ist und der Schaltkontakt geöffnet ist. In Abhängigkeit von dem ersten Widerstandswert und dem zweiten Widerstandswert bestimmt die Widerstandsmesseinrichtung den Widerstand des geschlossenen Schaltkontakts. Insbesondere wenn die Widerstandsmesseinrichtung mit der Ansteuereinheit zum Öffnen und Schließen des Schaltkontakts des Leistungsschalters gekoppelt ist, kann die Widerstandsmessung vollautomatisch durchgeführt werden. Beispielsweise kann nach Anschließen der Widerstandsmesseinrichtung an den elektrischen Leistungsschalter und beidseitiges Erden des Leistungsschalters zunächst automatisch der Schaltkontakt des Leistungsschalters geschlossen werden, dann der erste Widerstandswert gemessen werden und anschließend, nachdem der Schaltkontakt automatisch geöffnet wurde, der zweite Widerstandswert gemessen werden. Abschließend kann die Widerstandsmesseinrichtung gemäß der zuvor beschriebenen Gleichung den Widerstand des Schaltkontakts bestimmen und ausgeben.

Die Vorrichtung kann ferner zur Durchführung des zuvor beschriebenen Verfahrens oder einer seiner Ausführungsformen ausgestaltet sein und umfasst daher auch die zuvor beschriebenen Vorteile.

Gemäß der vorliegenden Erfindung wird weiterhin eine Testumgebung zur Messung eines Widerstands eines Schaltkontakts eines elektrischen Leistungsschalters bereitgestellt. Die Testumgebung umfasst den Leistungsschalter, eine erste und eine zweite Erdungsgarnitur und eine Widerstandsmesseinrichtung. Die erste Erdungsgarnitur ist mit einer ersten Seite des Leistungsschalters koppelbar, um die erste Seite des Leistungsschalters zu erden. Die zweite Erdungsgarnitur ist mit einer zweiten Seite des Leistungsschalters koppelbar, um diese zweite Seite zu erden. Die Widerstandsmesseinrichtung ist mit den beiden Seiten des Leistungsschalters derart koppelbar, dass mithilfe der Widerstandsmesseinrichtung ein erster Widerstandswert über dem Leistungsschalter bestimmbar ist, während der Leistungsschalter beidseitig geerdet und der Schaltkontakt geschlossen ist, und ein zweiter Widerstandswert über dem Leistungsschalter bestimmbar ist, während der Leistungsschalter beidseitig geerdet ist und der Schaltkontakt geöffnet ist. Mithilfe der Widerstandsmesseinrichtung ist ferner der Widerstand des geschlossenen Schaltkontakts in Abhängigkeit von dem ersten Widerstandswert und dem zweiten Widerstandswert bestimmbar.

Die vorliegende Erfindung wird nachfolgend unter Bezugnahme auf die beigefügte Zeichnung anhand bevorzugter Ausführungsformen erläutert werden.

Fig. 1 zeigt eine Testumgebung mit einem beidseitig geerdeten elektrischen Leistungsschalter und einer Vorrichtung zur Messung eines Widerstands eines Schaltkontakts des Leistungsschalters gemäß einer Ausführungsform der vorliegenden Erfindung.

Fig. 2-4 zeigen Testanordnungen mit Vorrichtungen zur Messung von Widerständen von Schaltkontakten von elektrischen Leistungsschaltern, welche jedoch keine Ausführungsformen der vorliegenden Erfindung darstellen.

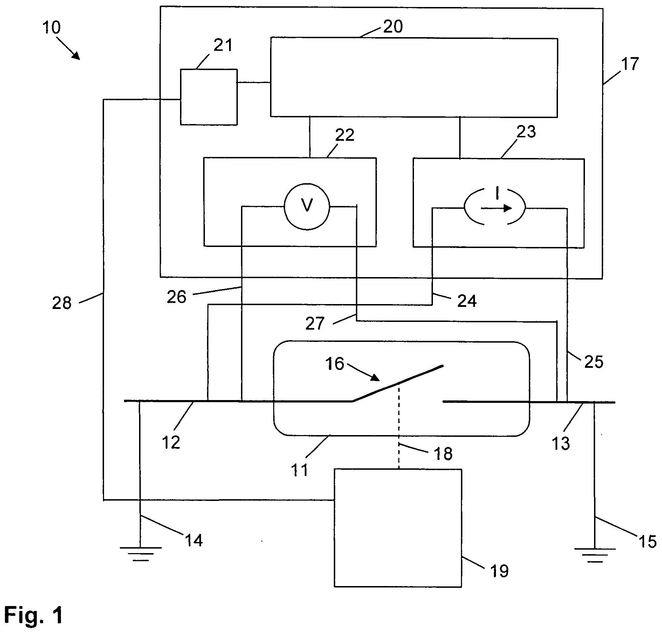

Fig. 1 zeigt eine Testumgebung 10 mit einem Leistungsschalter 11, welcher eine erste Hochspannungsleitung 12 wahlweise mit einer zweiten Hochspannungsleitung 13 verbindet oder davon trennt. Die Testumgebung 10 umfasst weiterhin eine erste Erdungsgarnitur 14, welche mit einer ersten Seite des Leistungsschalters 11 gekoppelt ist, und eine zweite Erdungsgarnitur 15, welche mit einer zweiten Seite des Leistungsschalters 11 gekoppelt ist. Durch das beidseitige Erden des Leistungsschalters kann sichergestellt werden, dass keine gefährlich hohen Spannungen an dem Leistungsschalter 11 anliegen. Die Testumgebung 10 umfasst weiterhin eine Mikroohmmessvorrichtung 17, welche über vier Verbindungen 24-27 mit den beiden Seiten des Leistungsschalters 11 gekoppelt ist. Der Leistungsschalter 11 umfasst einen elektrischen Schaltkontakt 16, welcher mittels eines Steuerantriebs 19 und einer mechanischen Kopplung 18 wahlweise geöffnet oder geschlossen werden kann, um eine Verbindung zwischen den Leitungen 12 und 13 herzustellen oder zu unterbrechen. Der Steuerantrieb 19 kann beispielsweise über eine Steuerleitung 28 angesteuert werden, um den Schaltkontakt 16 zu öffnen oder zu schließen. Darüber hinaus kann der Steuerantrieb 19 von einer Bedienperson manuell angesteuert oder betätigt werden, um den Schaltkontakt 16 wahlweise zu öffnen oder zu schließen.

Die Vorrichtung 17 umfasst eine Widerstandsmesseinrichtung, welche beispielsweise eine Stromquelle 23 und einen Spannungsmesser 22 umfasst. Die Stromquelle 23 prägt über die Verbindungen 24, 25 einen Strom I durch den Leistungsschalter 11 und die beidseitige Erdung 14, 15 ein und der Spannungsmesser 22 erfasst über die Verbindungen 26, 27 einen Spannungsabfall V über dem Leistungsschalter 11. Die Vorrichtung 17 umfasst weiterhin eine Verarbeitungseinheit 20, welche in Abhängigkeit von dem von der Stromquelle 23 eingeprägten Strom I und der von dem Spannungsmesser 22 gemessenen Spannung V einen Widerstand über dem Leistungsschalter 11 berechnet. Die Verarbeitungseinheit 20 ist ferner mit einer Ansteuereinheit 21 der Vorrichtung 17 gekoppelt, welche über die Verbindung 28 den Steuerantrieb 19 des Leistungsschalters 11 ansteuert. Somit ist die Verarbeitungseinheit 20 in der Lage, den Schaltkontakt 16 wahlweise zu öffnen oder zu schließen. Die Arbeitsweise der Vorrichtung 17 wird nachfolgend beschrieben werden.

Der Leistungsschalter 11 wird mithilfe der Erdungsgarnituren 14 und 15 beidseitig geerdet. Die Widerstandsmesseinrichtung 22, 23 wird, wie in Fig. 1 dargestellt, derart an den Leistungsschalter 11 angeschlossen, dass ein Widerstand über dem Leistungsschalter 11 messbar ist. Dann werden zwei Widerstandswerte nacheinander ermittelt. Ein Widerstandswert $R_1$ wird bei geschlossenem Schaltkontakt 16 ermittelt und ein Widerstandswert $R_2$ wird bei geöffnetem Schaltkontakt 16

ermittelt. Der Widerstand $R_1$ entspricht somit einer Parallelschaltung aus dem Widerstand des Schaltkontakts 16 und der Erdungsschleife über die Erdungsgarnituren 14, 15, und der Widerstand $R_2$ entspricht nur dem Widerstand der Erdungsschleife über die Erdungsgarnituren 14, 15. Mithilfe der weiter oben beschriebenen Gleichung kann aus diesen beiden Widerstandswerten der Widerstand des geschlossenen Schaltkontakts 16 berechnet werden. Dies wird von der Verarbeitungseinheit 20 durchgeführt. Die Verarbeitungseinheit 20 kann ferner über die Steuereinheit 21 den Schaltkontakt 16 wahlweise öffnen oder schließen und daher die beiden Widerstandsmessungen der Reihe nach einmal bei geöffnetem und einmal bei geschlossenem Schaltkontakt 16 durchführen und anschließend den Widerstand des geschlossenen Schaltkontakts 16 daraus berechnen. Eine Reihenfolge, in welcher die beiden Widerstandsmessungen durchgeführt werden, ist beliebig. Alternativ kann die Verarbeitungseinheit 20 über eine entsprechende Anzeige einen Benutzer anweisen, den Schaltkontakt 16 manuell oder über eine entsprechende Betätigungsvorrichtung zu öffnen oder zu schließen, wenn eine automatische Ansteuerung über die Ansteuereinheit 21 und die Verbindung 28 nicht vorgesehen ist. Da während der gesamten Messung der Leistungsschalter 11 beidseitig geerdet ist, kann sichergestellt werden, dass keine gefährlich hohen Spannungen an dem Leistungsschalter 11 anliegen.

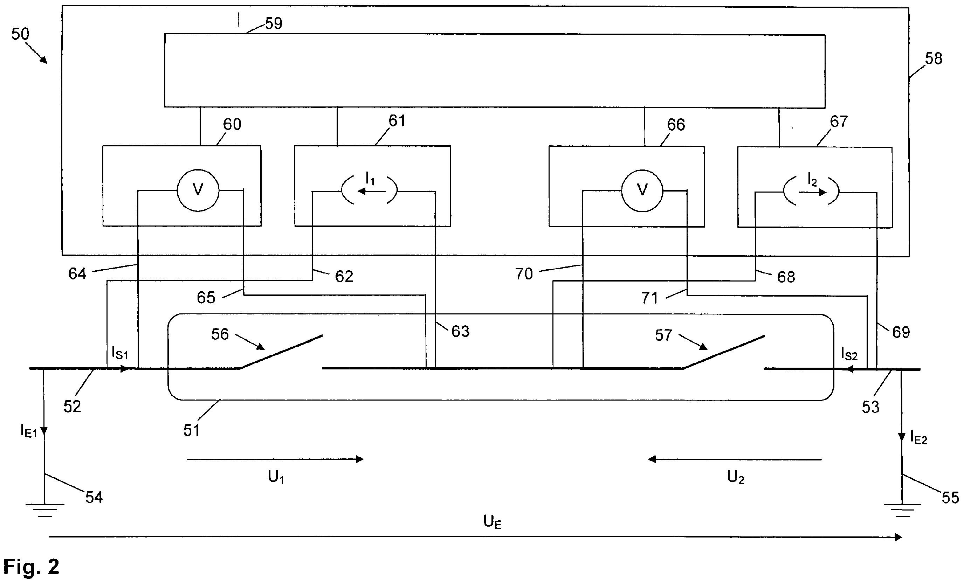

Fig. 2 zeigt eine weitere Testumgebung 50 mit einem Leistungsschalter 51, welcher zwei Schaltkontakte 56 und 57 umfasst. Die Schaltkontakte 56 und 57 sind in einer Reihenschaltung angeordnet. Der Leistungsschalter 51 kann weitere Schaltkontakte umfassen, welche zusammen mit den Schaltkontakten 56 und 57 in einer Reihenschaltung angeordnet sind. Die Schaltkontakte 56 und 57 und die gegebenenfalls vorhandenen weiteren Schaltkontakte werden im Allgemeinen gleichzeitig mittels eines nicht gezeigten Stellantriebs wahlweise geöffnet oder geschlossen. Der Leistungsschalter 51 ist mit Hochspannungsleitungen 52 und 53 gekoppelt, welche über die Schaltkontakte 56, 57 wahlweise verbunden oder getrennt werden können. Die Testumgebung 50 umfasst ferner zwei Erdungsgarnituren 54 und 55, welche die Hochspannungsleitungen 52 bzw. 53 mit Erde verbinden. Weiterhin ist in der Testumgebung 50 eine Vorrichtung 58 zur Messung des Widerstandes der Schaltkontakte 56 und 57 gezeigt. Die Vorrichtung 58 umfasst eine erste Widerstandsmesseinheit, welche einen Spannungsmesser 60 und eine Stromquelle 61 umfasst, sowie eine zweite Widerstandsmesseinheit, welche einen Spannungsmesser 66 und eine Stromquelle 67 umfasst. Die erste Widerstandsmesseinrichtung 60, 61 ist über Verbindungen 62-65 mit dem ersten Schaltkontakt 56 derart verbunden, dass ein Strom $I_1$ der Stromquelle 61 über den Schaltkontakt 65 eingeprägt werden kann, wenn der Schaltkontakt 56 geschlossen ist. Der Spannungsmesser ist über die Verbindungen 64 und 65 derart mit dem Schaltkontakt 56 verbunden, dass

ein Spannungsabfall $U_1$ über dem Schaltkontakt 56 gemessen werden kann. Die zweite Widerstandsmesseinrichtung 66, 67 ist vergleichbar zu der ersten Widerstandsmesseinrichtung 60, 61 mit dem Schaltkontakt 57 über Verbindungen 68-71 zum Einprägen eines Stroms $I_2$ durch den geschlossenen Schaltkontakt 57 und Messen eines Spannungsabfalls $U_2$ über dem Schaltkontakt 57 gekoppelt. Eine Verarbeitungseinheit 59 ist mit den Widerstandsmesseinrichtungen 60, 61 bzw. 66, 67 verbunden. Die Arbeitsweise der Vorrichtung 58 wird nachfolgend beschrieben werden.

Die Hochspannungsleitungen 52, 53, welche an beiden Enden des Leistungsschalters 51 angeschlossen sind, werden über die Erdungsgarnituren 54, 55 mit Erde verbunden. Die Vorrichtung 58 wird wie zuvor beschrieben an die Schaltkontakte 56 und 57 angeschlossen. Die Schaltkontakte 56 und 57 werden geschlossen. Von der Stromquelle 61 wird ein Strom $I_1$ auf die Hochspannungsleitung 52 eingeprägt. Der Strom $I_1$ fließt daher zum Teil als Strom $I_{S1}$ von links nach rechts durch den geschlossenen Schaltkontakt 56 und zu einem anderen Teil als Strom $I_{E1}$ über die Erdungsgarnitur 54 nach Erde ab. Die Stromquelle 67 prägt einen Strom $I_2$ auf die Hochspannungsleitung 53 ein. Der Strom $I_2$ fließt zum Teil als Strom $I_{S2}$ von rechts nach links durch den geschlossenen Schaltkontakt 57 und zu einem weiteren Teil als Strom $I_{E2}$ durch die Erdungsgarnitur 55 nach Erde ab. Aufgrund des Übergangswiderstands des Schaltkontakts 56 tritt über dem Schaltkontakt 56 ein Spannungsabfall $U_1$ auf. Ebenso tritt aufgrund des Übergangswiderstands des Schaltkontakts 57 ein Spannungsabfall $U_2$ über dem Schaltkontakt 57 auf. Da die Ströme $I_{S1}$ und $I_{S2}$ entgegengesetzt gerichtet eingespeist werden, sind die Spannungsabfälle $U_1$ und $U_2$ ebenfalls entgegengesetzt gerichtet. Wenn die Übergangswiderstände der Schaltkontakte 56 und 57 im Wesentlichen gleich sind und darüber hinaus die Ströme $I_1$ und $I_2$ im Wesentlichen gleich sind, sind die Spannungsabfälle $U_1$ und $U_2$ ebenfalls betragsmäßig gleich. Dadurch ist der Spannungsabfall $U_E$ über der Erdungsschleife gleich null, sodass auch die Ströme $I_{E1}$ und $I_{E2}$ jeweils null sind. In diesem Fall entspricht der Strom $I_{S1}$ durch den Schaltkontakt 56 dem Strom $I_1$, sodass der Übergangswiderstand des Schaltkontakts 56 einzig in Abhängigkeit von dem Strom $I_1$ und der von dem Spannungsmesser 60 gemessenen Spannung $U_1$ bestimmt werden kann. Ebenso kann der Übergangswiderstand des geschlossenen Schaltkontakts 57 einzig anhand des Stroms $I_2$, welcher in diesem Fall dem Strom $I_{S2}$ entspricht, und der von dem Spannungsmesser 66 gemessenen Spannung $U_2$ bestimmt werden. Da die Schaltkontakte 56 und 57 im Allgemeinen baugleich sind und einer gleichen Beanspruchung unterliegen, weisen sie im Allgemeinen einen gleichen Übergangswiderstand im geschlossenen Zustand auf, sodass die zuvor beschriebenen Bedingungen erfüllt werden und für diesen sogenannten symmetrischen Fall eine einfache und genaue Bestimmung der Übergangswiderstände möglich ist. Die Verarbeitungseinheit 59 kann die entsprechenden Widerstandswerte anhand von Informationen der Widerstandsmesseinrichtungen 60, 61 und 66, 67 bestimmen und ausgeben. Für den Fall, dass die Übergangswiderstände der Schaltkontakte 56 und 57 unterschiedlich groß sind, kann die Steuervorrichtung 59 die Ströme $I_1$ und $I_2$ derart einstellen, dass die Spannungsabfälle $U_1$ und $U_2$ betragsmäßig im Wesentlichen gleich sind. Dadurch wird erreicht, dass auch in diesem nicht symmetrischen Fall die Spannung $U_E$ über der Erdungsschleife im Wesentlichen null beträgt und somit der Übergangswiderstand der einzelnen Schaltkontakte 56 und 57 anhand des Stroms $I_1$ bzw. $I_2$ und der Spannungsabfälle $U_1$ bzw. $U_2$ bestimmt werden können.

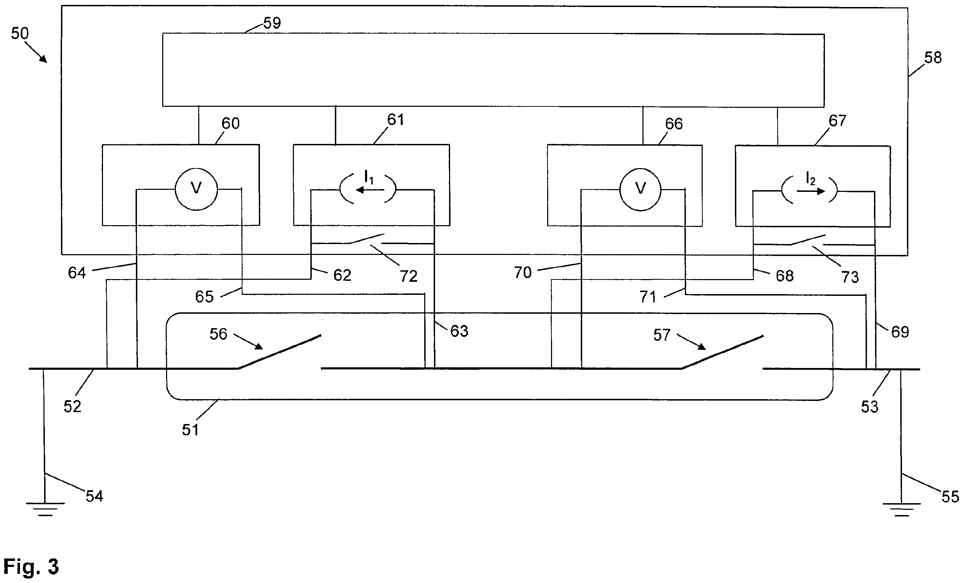

Fig. 3 zeigt eine weitere Testumgebung 50, welche im Wesentlichen der Testumgebung 50 der Fig. 2 entspricht und darüber hinaus zwei zusätzliche Schalter 72 und 73 umfasst, welche parallel zu den Schaltkontakten 56 bzw. 57 angeordnet sind. Dadurch wird ermöglicht, dass auch bei geöffneten Schaltkontakten 56 bzw. 57 ein Strom durch die Erdungsschleife, welche über die Erdungsgarnituren 54 und 55 realisiert wird, getrieben werden kann, um den Widerstand der Erdschleife ermitteln zu können. Der Widerstand der Erdschleife kann dann zur Korrektur von Widerstandswerten verwendet werden, welche bei geschlossenen Schaltkontakten 56, 57 ermittelt werden. Anders ausgedrückt kann mithilfe der Schalter 72, 73 auch bei der in Fig. 3 gezeigten Anordnung das im Zusammenhang mit Fig. 1 beschriebene Verfahren durchgeführt werden. Beispielsweise kann der Schalter 73 geschlossen und der Schalter 72 geöffnet werden. Eine Mikroohmmessung des Schaltkontakts 56 kann dann mithilfe der Widerstandsmesseinrichtung 60, 61 wie zuvor unter Bezugnahme auf Fig. 1 beschrieben durchgeführt werden. Bei geschlossenem Schalter 72 und geöffnetem Schalter 73 kann mithilfe der Widerstandsmesseinrichtung 66, 67 eine Mikroohmmessung an dem Schaltkontakt 57 wie zuvor unter Bezugnahme auf Fig. 1 beschrieben durchgeführt werden.

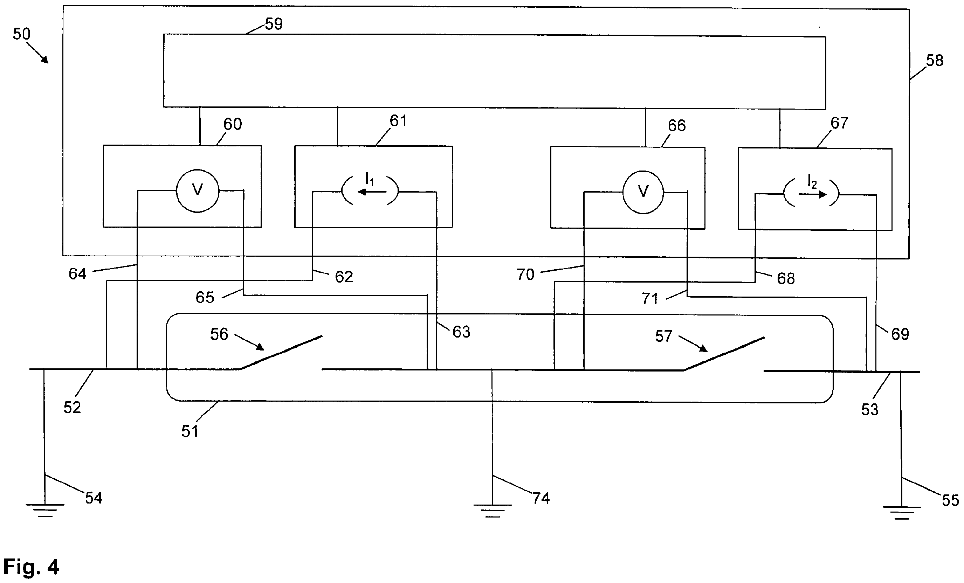

Fig. 4 zeigt eine Testumgebung 50, welche im Wesentlichen der Testumgebung 50 der Fig. 2 entspricht. Zusätzlich umfasst die Testumgebung 50 der Fig. 4 eine dritte Erdungsgarnitur 74, welche einen Punkt zwischen dem Schaltkontakt 56 und dem Schaltkontakt 57 mit Erde koppelt. Bei dieser Anordnung kann mithilfe der Widerstandsmesseinrichtung 60, 61 eine Mikroohmmessung des Schaltkontakts 56 wie unter Bezugnahme auf Fig. 1 zuvor beschrieben wurde durchgeführt werden. Ebenso kann mithilfe der Widerstandsmesseinrichtung 66, 67 eine Mikroohmmessung des Schaltkontakts 57 wie zuvor unter Bezugnahme auf Fig. 1 beschrieben durchgeführt werden. Die beiden Mikroohmmessungen an den Schaltkontakten 56 und 57 können gleichzeitig durchgeführt werden. Durch diese zusätzliche Erdung 74 kann ferner sichergestellt werden, dass auch zwischen den Schaltkontakten 56 und 57 keine Hochspannung anliegt.

**Patentansprüche**

1. Verfahren zur Messung eines Widerstands eines Schaltkontakts eines elektrischen Leistungsschalters, umfassend:

   - Bestimmen eines ersten Widerstandswerts über dem Leistungsschalter (11), während der Leistungsschalter (11) beidseitig geerdet ist und der Schaltkontakt (16) geschlossen ist,

   **dadurch gekennzeichnet, dass** das Verfahren ferner umfasst:

   - Bestimmen eines zweiten Widerstandswerts über dem Leistungsschalter (11), während der Leistungsschalter (11) beidseitig geerdet ist und der Schaltkontakt (16) geöffnet ist, und
   - Bestimmen des Widerstands des geschlossenen Schaltkontakts (16) in Abhängigkeit von dem ersten Widerstandswert und dem zweiten Widerstandswert.

2. Verfahren nach Anspruch 1, wobei das Bestimmen des ersten und zweiten Widerstandswerts jeweils umfasst:

   - Einprägen eines Gleichstroms in den beidseitig geerdeten Leistungsschalter (11), und
   - Messen einer Spannung über dem Leistungsschalter (11).

3. Verfahren nach Anspruch 1 oder 2, wobei der Leistungsschalter (11) einen Dreiphasenschalter umfasst, wobei jeder Phase mindestens ein Schaltkontakt zugeordnet ist.

4. Verfahren nach einem der vorhergehenden Ansprüche, wobei das Verfahren gleichzeitig für mehrere Schaltkontakte des Leistungsschalters durchgeführt wird.

5. Verfahren nach einem der vorhergehenden Ansprüche, wobei der Leistungsschalter (11) einen Höchst-, Hoch- oder Mittelspannungsschalter umfasst.

6. Vorrichtung zur Messung eines Widerstands eines Schaltkontakts eines elektrischen Leistungsschalters, umfassend:

   - eine Widerstandsmesseinrichtung (20, 22, 23), welche ausgestaltet ist, einen ersten Widerstandswert über dem Leistungsschalter (11) zu bestimmen, während der Leistungsschalter (11) beidseitig geerdet ist und der Schaltkontakt (16) geschlossen ist,

   **dadurch gekennzeichnet, dass** die Vorrichtung ferner umfasst:

- eine Ansteuereinheit (21) zum Ansteuern des elektrischen Leistungsschalters (11), um den Schaltkontakt (16) des Leistungsschalters (11) wahlweise zu öffnen oder zu schließen,

wobei die Widerstandsmesseinrichtung (20, 22, 23) mit der Ansteuereinheit (21) koppelbar ist und ausgestaltet ist, einen zweiten Widerstandswert über dem Leistungsschalter (11) zu bestimmen, während der Leistungsschalter (11) beidseitig geerdet ist und der Schaltkontakt (16) geöffnet ist, und den Widerstand des geschlossenen Schaltkontakts (16) in Abhängigkeit von dem ersten Widerstandswert und dem zweiten Widerstandswert zu bestimmen.

7. Vorrichtung nach Anspruch 6, wobei die Vorrichtung (17) zur Durchführung des Verfahrens nach einem der Ansprüche 1-5 ausgestaltet ist.

8. Testumgebung zur Messung eines Widerstands eines Schaltkontakts eines elektrischen Leistungsschalters, umfassend:

- den Leistungsschalter (11),
- eine Vorrichtung (17) nach Anspruch 6 oder 7,
- eine erste Erdungsgarnitur (14), welche zur Erdung einer ersten Seite des Leistungsschalters (11) mit dem Leistungsschalter (11) koppelbar ist, und
- eine zweite Erdungsgarnitur (15), welche zur Erdung einer zweiten Seite des Leistungsschalters (11) mit dem Leistungsschalter (11) koppelbar ist.

**Claims**

1. A method for the measurement of a resistance of a switching contact of an electrical circuit breaker, comprising:

- determining a first resistance value across the circuit breaker (11) while the circuit breaker (11) is grounded at both sides and the switching contact (16) is closed, **characterized in that** the method further comprises:
- determining a second resistance value across the circuit breaker (11) while the circuit breaker (11) is grounded at both sides and the switching contact (16) is open, and
- determining the resistance of the closed switching contact (16) on the basis of the first resistance value and the second resistance value.

2. The method according to claim 1, wherein the determining of the first and second resistance values respectively comprises:

- impressing a direct current in the circuit breaker (11) which is grounded at both sides, and
- measuring a voltage across the circuit breaker (11).

3. The method according to claim 1 or claim 2, wherein the circuit breaker (11) comprises a three-phase switch, each phase being assigned to a switching contact.

4. The method according to any one of the preceding claims, wherein the method is simultaneously carried out for a plurality of switching contacts of the circuit breaker.

5. The method according to any one of the preceding claims, wherein the circuit breaker (11) comprises an ultra-high voltage switch, a high voltage switch, or a medium voltage switch.

6. An apparatus for the measurement of a resistance of a switching contact of an electrical circuit breaker, comprising:

- a resistance measurement device (20, 22, 23) which is configured to determine a first resistance value across the circuit breaker (11) while the circuit breaker (11) is grounded at both sides and the switching contact (16) is closed,

**characterized in that** the apparatus further comprises:

- a control unit (21) for controlling the electrical circuit breaker (11) to selectively open or close the switching contact (16) of the circuit breaker (11),

wherein the resistance measurement device (20, 22, 23) is configured to be coupled to the control unit (21) and is configured to determine a second resistance value across the circuit breaker (11) while the circuit breaker (11) is grounded at both sides and the switching contact (16) is open, and to determine the resistance of the closed switching contact (16) on the basis of the first resistance value and the second resistance value.

7. The apparatus according to claim 6, wherein the apparatus (17) is configured to carry out the method according to any one of claims 1-5.

8. A test environment for the measurement of a resistance of a switching contact of an electrical circuit breaker, comprising:

- the circuit breaker (11),
- the apparatus according to claim 6 or claim 7,
- a first grounding device (14) which is configured to be coupled with the circuit breaker (11) for grounding a first side of the circuit breaker (11),
- a second grounding device (15) which is configured to be coupled with the circuit breaker (11) for grounding a second side of the circuit breaker (11).

**Revendications**

1. Procédé de mesure de la résistance d'un contact de commutation d'un disjoncteur électrique, comprenant :

   - la détermination d'une première valeur de la résistance aux bornes du disjoncteur (11) lorsque le disjoncteur (11) est mis à la masse des deux côtés et que le contact de commutation (16) est fermé,

   **caractérisé en ce que** le procédé comprend en outre :

   - la détermination d'une seconde valeur de la résistance aux bornes du disjoncteur (11) lorsque le disjoncteur (11) est mis à la masse des deux côtés et que le contact de commutation (16) est ouvert, et
   - la détermination de la résistance du contact de commutation (16) fermé en fonction de la première valeur de la résistance et de la seconde valeur de la résistance.

2. Procédé selon la revendication 1, dans lequel la détermination des première et seconde valeurs de la résistance comprend chacune:

   - l'introduction d'un courant continu dans le disjoncteur (11) mis à la masse des deux côtés et
   - la mesure d'une tension aux bornes du disjoncteur (11).

3. Procédé selon la revendication 1 ou 2, dans lequel le disjoncteur (11) comprend un disjoncteur triphasé, dans lequel chaque phase est associée à au moins un contact de commutation.

4. Procédé selon l'une des revendications précédentes, dans lequel le procédé est exécuté simultanément pour plusieurs contacts de commutation du disjoncteur.

5. Procédé selon l'une des revendications précédentes, dans lequel l'interrupteur de puissance (11) comprend un disjoncteur de tension maximale, un disjoncteur de tension élevée ou un disjoncteur de tension moyenne.

6. Dispositif pour mesurer une résistance d'un contact de commutation d'un disjoncteur électrique, comprenant:

   - un dispositif de mesure de la résistance (20, 22, 23) configuré pour déterminer une première valeur de la résistance aux bornes du disjoncteur (11) pendant que le disjoncteur (11) est mis à la masse des deux côtés et que le contact de commutation (16) est fermé

   **caractérisé en ce que** le dispositif comprend en outre:

   - une unité de commande (21) pour commander le disjoncteur (11), pour ouvrir ou fermer sélectivement le contact de commutation (16),

   dans lequel le dispositif de mesure de la résistance (20, 22, 23) peut être couplé avec l'unité de commande (21) et est configuré pour déterminer une seconde valeur de la résistance aux bornes du disjoncteur (11) pendant que le disjoncteur (11) est mis à la masse des deux côtés et que le contact d'interrupteur (16) est ouvert, et pour déterminer la résistance du contact de commutation (16) fermé en fonction de la première valeur de la résistance et de la seconde valeur de la résistance.

7. Appareil selon la revendication 6, dans lequel le dispositif (17) est conçu pour exécuter le procédé selon l'une quelconque des revendications 1 à 5.

8. Environnement de test pour mesurer une résistance d'un contact de commutation d'un disjoncteur électrique, comprenant:

   - le disjoncteur (11),
   - un dispositif (17) selon la revendication 6 ou 7,
   - un premier ensemble de mise à la masse (14) pouvant être couplé au disjoncteur (11) pour mettre à la masse un premier côté du disjoncteur (11), et
   - un second ensemble de mise à la masse (15) pouvant être couplé au disjoncteur (11) pour mettre à la masse un second côté du disjoncteur (11).

**Fig. 1**

Fig. 2

Fig. 3

**Fig. 4**

EP 2 700 962 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **NILS WÄCKLEN et al.** High voltage circuit breaker testing with dual grounding. *ENERGIZE,* 01. Mai 2008, 52-55